# EUROPEAN PATENT APPLICATION

(11) **EP 0 805 457 A2**
(43) Date of publication of application: **05.11.1997**
(21) Application number: 97302537.2
(22) Date of filing: 14.04.1997
(51) Int. Cl.: G11C 15/04

(54) **Contents addressable memories**

(30) Priority: 01.05.1996 GB 9609075
(71) Applicant: PLESSEY SEMICONDUCTORS LIMITED, Swindon, Wiltshire SN2 2QW (GB)
(72) Inventor: Albon, Richard, Tavistock, Devon PL19 9PR (GB); Martin, Alan, Plymouth, Devon PL3 6JW (GB)
(74) Representative: Hoste, Colin Francis

(57) **Abstract**

Each cell 23 of a contents addressable memory (CAM) comprises three comparator circuits 38, 39, 40 and respective latches 44, 45, 46. This arrangement allows three simultaneous comparison operations to be carried out against a bit value stored in memory element 12. Also, read access path 27 and write access path 22 are separate from the access paths 35, 36, 37 used for comparison purposes. In this way, read, write and comparison operations can be carried out contemporaneously, though not to the same row, allowing updating of cells 23 with minimum disruption to the CAM's operation.

## Description

The present invention relates to contents addressable memories (CAMs).

Contents addressable memories are useful in applications where memory searching is required. Such applications include optical and magnetic disk caches, data base accelerators, machine vision, target acquisition and artificial intelligence machines.

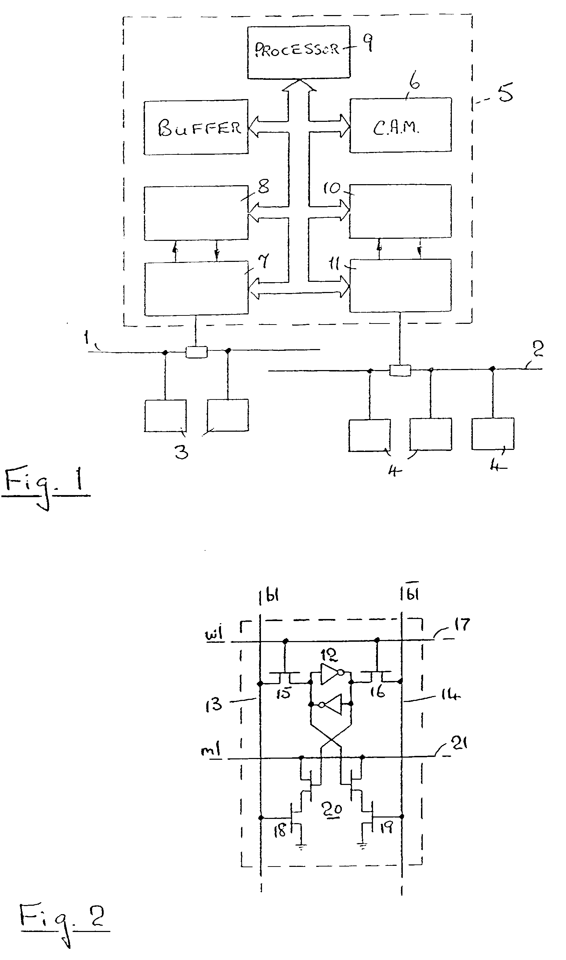

Contents addressable memories may also be used in local area networks (LANs) to store the network addresses of nodes accessible in an area or segment of a network, the different segments of a network being connected by bridge circuit arrangements, as indicated in Figure 1.

The performance of such bridge arrangements is limited by the rate at which incoming address data can be compared with node address data which has been written into the memory during initialisation, the incoming address data bits being presented to respective columns of cells of the memory along the bit-line and bit-line-bar paths by which the stored data bits were written in. Patent Application GB-A-2277617 describes a contents addressable memory which may be used for such comparisons, this memory having a single comparison circuit in each cell and a match line device to indicate a match of incoming data and data stored in a row of memory cells. Only one comparison process can be carried out at a time, therefore, with succeeding sets of address data having to wait their turn in a buffer store, and the sequence of comparisons has to be interrupted if the node address contents of the memory have to be updated to reflect changes to the network, since the writing and comparison processes both use the bit-lines for access.

According to a first aspect of the present invention there is provided a contents addressable memory comprising an array of random access memory cells arranged in rows and columns, wherein there are provided in respect of each column of cells a plurality of data bit value input paths extending to each cell of the column and in respect of each row of cells a like plurality of match line paths extending to each cell of the row, and each cell comprises a like plurality of comparison circuit means whereby a set of data bit values applied to respective ones of said plurality of input paths may be compared with data values held in respective cells of a row of cells and an indication given on a respective match line path if the respective data bit values of said set match the respective data bit values held in the cells of said row.

In accordance with a second aspect of the present invention there is provided a contents addressable memory comprising an array of random access memory cells arranged in rows and columns, wherein there are provided in respect of each column of cells a plurality of data bit value input paths extending to each cell of the column and in respect of each row of cells, a like plurality of match line paths extending to each cell of the row, and each cell comprises a like plurality of comparison circuit means for comparing a data bit value applied to a respective one of said plurality of input paths with a data value held in the cell and for controlling the condition of switch means associated with a respective match line path in dependence upon the result of that comparison.

In accordance with a third aspect of the present invention there is provided a contents addressable memory comprising an array of random access memory cells arranged in rows and columns and means for selectively storing data bit values in and reading data bit values from memory cells of said array, wherein there are provided a plurality of comparand bit value registers and, in each of said memory cells, a like plurality of comparison circuit means, and there are provided means to apply respective comparand bit values from a respective one of said comparand registers to respective comparison circuit means in each cell of respective columns of cells of the array and a like plurality of match line means associated with each row of cells of the array, each of said match line means being arranged to give an indication if the respective bit values from a respective comparand register match the data bit values stored in the associated row of cells.

In accordance with a fourth aspect of the present invention there is provided a contents addressable memory comprising an array of random access memory cells arranged in rows and columns wherein each cell is provided with comparison circuit means for comparing a data bit value applied to a data bit value input path, the data bit value input path extending to every cell in a column, with a data value held in the cell and for controlling the condition of switch means associated with a match line, the match line extending to every cell in a row, in dependence upon the result of that comparison characterised in that each cell is provided with a plurality of comparison circuit means and the memory is provided with a like plurality of match lines for every row of cells and a like plurality of data bit value input paths for every column of cells.

A contents addressable memory in accordance with the present invention will now be described by way of example with reference to the accompanying drawings, of which:-
Figure 1 shows schematically a bridge circuit arrangement for a local area network incorporating a contents addressable memory,
Figure 2 shows diagrammatically a memory cell of a known form of contents addressable memory,
Figure 3 shows schematically a contents addressable memory in accordance with the present invention,
Figure 4 shows diagrammatically one cell of the memory shown in Figure 3, and
Figure 5 shows in more detail the contents addressable memory of Figure 3.

Referring first to Figure 1, as outlined above in a local area network different areas or segments of the network, represented by transmission paths or media 1 and 2 serving respective nodes 3 and 4, may be interconnected by way of a bridge circuit arrangement 5. Only two segments are shown, but it will be appreciated that a larger number of segments may be interconnected provided that the bridge 5 is capable of handling the traffic. The bridge includes a contents addressable memory 6 in which address data included in signals received, say, from one segment 1 by way of interface circuits 7 and 8 under the control of a processor 9 may be compared with node address data previously entered in the memory 6, the signals then being routed, where appropriate, by way of further interface circuits 10 and 11 to the segment 2.

Figure 2 shows one cell of a known form of contents addressable memory, in which a random access memory element 12, represented as a pair of inverters, is accessed from data bit lines 13 and 14 by way of access transistors 15 and 16, respectively, which are selectively switched on by signals on a word line 17. The data bit lines 13 and 14 are also connected to gate electrodes of transistors 18 and 19 of a comparison circuit 20, which serves to ground a match line 21 during a comparison process unless the data bit value then present on the bit lines 13 and 14 matches the data bit value held by the memory element 12.

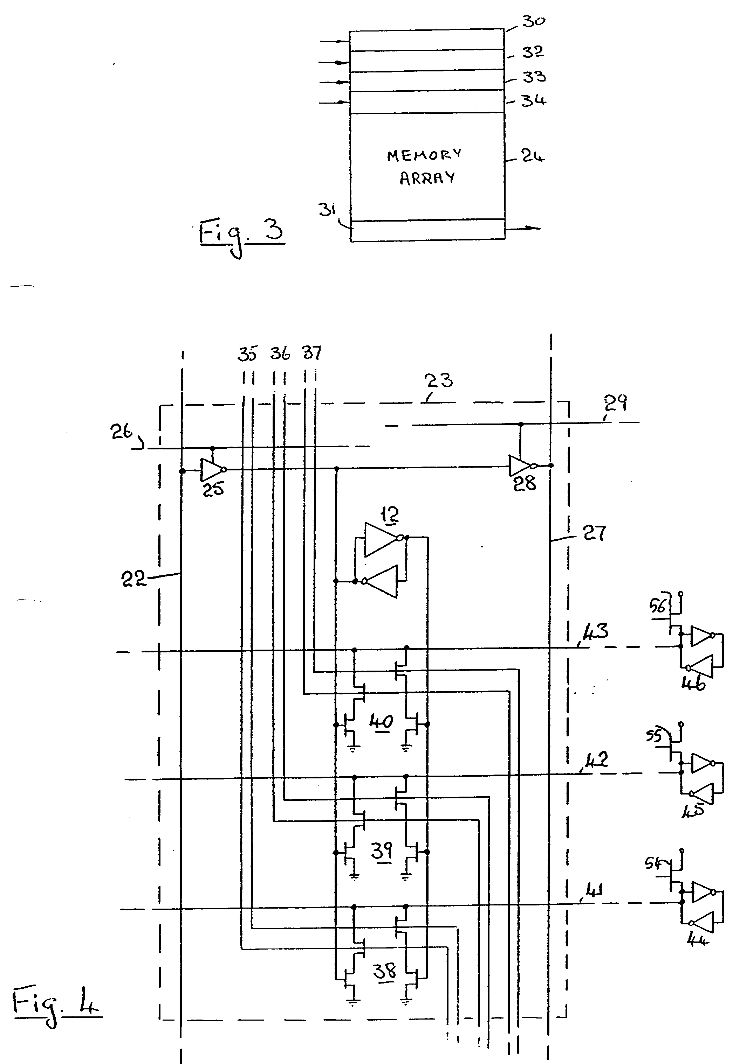

Referring now to Figures 3 and 4, in a contents addressable memory in accordance with the present invention the write/read access paths are separate from the access paths used for comparison purposes. Thus the write access path or data write line 22 to a cell 23 in the memory array 24 is connected to the memory element 12 of the cell 23 by way of an inverter 25 under the control of signals on a word write line or write enable line 26, and the read access path or data read line 27 is connected to the memory element 12 by way of an inverter 28 under the control of signals on a word read line or read enable line 29. The data bit values to be written into the memory array 24 may be derived from a data input register 30, while data bit values read from the memory array may be passed to a data output register 31.

Incoming sets of data bit values for comparison with node address data bits held in the memory array 24 may be entered in their respective sets in comparand registers 32, 33 and 34 each corresponding in length to the length of a row of cells of the array 24. From these comparand registers individual bit values and their inverses are applied to the cells 23 of respective columns by way of paths 35, 36 and 37 respectively, where the comparand bit values are compared in respective comparison circuits 38, 39 and 40 with the node address bit values held in the cells 23.

A match between the bit values of a comparand register 32, 33 or 34 and the data bit values stored in a row of cells is identified by the provision of a match line 43, 42, 41 and a latch 46, 45, 44 for each comparison circuit 38, 39, 40. Before a comparing operation, the match line 43, 42 or 41 is driven high by applying a pulse to the control electrode of a transistor 56, 55 or 54, to operate the respective latch 46, 45 or 44. In a comparing operation, where the comparand values match the stored values along a row of cells, the respective match line 41, 42 or 43 will remain high but, where the comparand bit value does not match the bit value stored in a cell, the comparison circuit 38, 39 or 40 will ground its respective match line 41, 42 or 43 and respective latch 44, 45, 46 will show that there was not a match.

As an alternative, match detection could be carried out by an arrangement having the match line of a row of cells connecting an output transistor of each cell of that row in series, the line only conducting current if all of the cells in that row have their output transistor turned on, a match being detected using a current sensing circuit at one end of the match line. Such an arrangement is described in Patent Application GB-A-2277617.

Since the access to the comparison circuits 38, 39 and 40 is entirely separate from the write and read accesses to the memory elements 12, write, read and comparison processes may occur contemporaneously, although not to the same row, allowing updating of the bit value stored in cell 23 with minimum disruption to the CAM's operation. In the form of memory shown in Figures 3 and 4 up to three comparisons may be taking place at any one time and not necessarily synchronously.

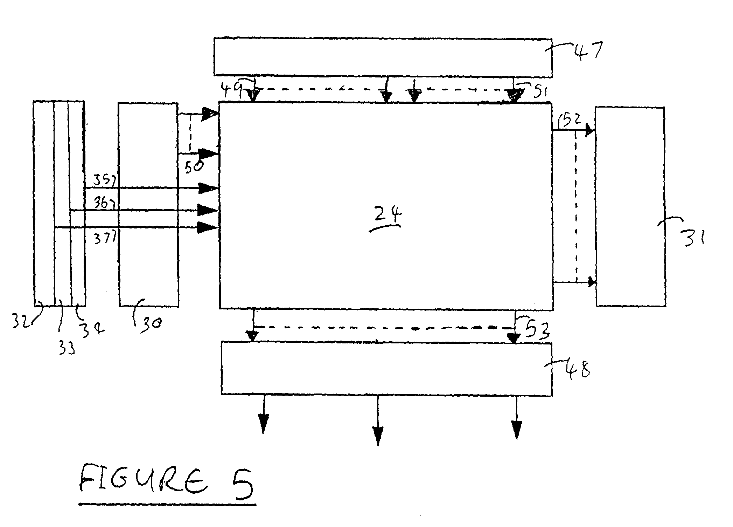

Referring now to Figure 5, a contents addressable memory such as that shown in Figure 3 further comprises read and write row decoder 47 and priority encoder 48. In this figure, memory array 24 comprises 256 rows by 64 columns of the CAM cells of Figure 4.

In a write operation, read and write row decoder 47 enables one or more of the 256 write lines 49, one of which is write enable line 26, and data is written from data input register 30 into the required cell or cells by way of one or more of data input lines 50, one of which is the data write line 22. Similarly, in a read operation, read and write row decoder 47 enables one or more of the 256 read lines 51 of a column of cells, one of which is the read enable line 29, and data is read from the relevant cells into data output register 31 by way of one or more data output lines 52, one of which is data read line 27.

Data from each comparand register 32, 33 and 34 is communicated to each cell 23 of array 24 by respective paths 35, 36 and 37. Although only one path 35, 36, 37 is shown connecting each comparand register to array 24, it will be understood that each path actually comprises 64 x 2 lines to provide connection between each register 32, 33, 34 and each cell 23 in array 24.

A data match is indicated to priority encoder 48 on one of the 768 match lines 53. These match lines 53 correspond to the match lines 41, 42 and 43 of the cell of Figure 4, though there are three match lines per row making a total of 768.

Priority encoder 48 serves to output the identity of the row which has the highest priority and indicated a match, for each of the comparand registers 32, 33 and 34. A priority encoder suitable for this purpose is described in Patent Application GB-A-2277616.

It will be appreciated that if space permitted, more than three comparison circuits could be provided in each cell.

## Claims

1. A contents addressable memory comprising an array of random access memory cells arranged in rows and columns, wherein there are provided in respect of each column of cells a plurality of data bit value input paths extending to each cell of the column and in respect of each row of cells a like plurality of match line paths extending to each cell of the row, and each cell comprises a like plurality of comparison circuit means whereby a set of data bit values applied to respective ones of said plurality of input paths may be compared with data values held in respective cells of a row of cells and an indication given on a respective match line path if the respective data bit values of said set match the respective data bit values held in the cells of said row.

2. A contents addressable memory comprising an array of random access memory cells arranged in rows and columns, wherein there are provided in respect of each column of cells a plurality of data bit value input paths extending to each cell of the column and in respect of each row of cells, a like plurality of match line paths extending to each cell of the row, and each cell comprises a like plurality of comparison circuit means for comparing a data bit value applied to a respective one of said plurality of input paths with a data value held in the cell and for controlling the condition of switch means associated with a respective match line path in dependence upon the result of that comparison.

3. A contents addressable memory in accordance with claim 2 in which the switch means comprises means to cause the match line path to assume a predetermined voltage.

4. A contents addressable memory in accordance with claim 2 in which the switch means comprises means to reduce the impedance of a section of the match line path.

5. A contents addressable memory comprising an array of random access memory cells arranged in rows and columns and means for selectively storing data bit values in and reading data bit values from memory cells of said array, wherein there are provided a plurality of comparand bit value registers and, in each of said memory cells, a like plurality of comparison circuit means, and there are provided means to apply respective comparand bit values from a respective one of said comparand registers to respective comparison circuit means in each cell of respective columns of cells of the array and a like plurality of match line means associated with each row of cells of the array, each of said match line means being arranged to give an indication if the respective bit values from a respective comparand register match the data bit values stored in the associated row of cells.

6. A contents addressable memory comprising an array of random access memory cells arranged in rows and columns wherein each cell is provided with comparison circuit means for comparing a data bit value applied to a data bit value input path, the data bit value input path extending to every cell in a column, with a data value held in the cell and for controlling the condition of switch means associated with a match line, the match line extending to every cell in a row, in dependence upon the result of that comparison characterised in that each cell is provided with a plurality of comparison circuit means and the memory is provided with a like plurality of match lines for every row of cells and a like plurality of data bit value input paths for every column of cells.

7. A contents addressable memory in accordance with claim 6 in which the switch means comprises means to cause the match line path to assume a predetermined voltage.

8. A contents addressable memory in accordance with claim 6 in which the switch means comprises means to reduce the impedance of a section of the match line path.
